# EUROPEAN PATENT APPLICATION

(11) **EP 4 614 486 A1**
(43) Date of publication of application: **10.09.2025**
(21) Application number: 23917858.5
(22) Date of filing: 26.10.2023
(51) Int. Cl.: G09F 9/302, G09F 9/33, G06F 1/16, H01L 27/15, H01L 25/075

(54) **DISPLAY DEVICE**

(30) Priority: 18.01.2023 KR 20230007667
(71) Applicant: Samsung Electronics Co., Ltd., Suwon-si, Gyeonggi-do 16677 (KR)
(72) Inventor: KIM, Seungjae, Suwon-si Gyeonggi-do 16677 (KR); KIM, Jisu, Suwon-si Gyeonggi-do 16677 (KR); OH, Pilyong, Suwon-si Gyeonggi-do 16677 (KR); LEE, Kwangjae, Suwon-si Gyeonggi-do 16677 (KR)
(74) Representative: Appleyard Lees IP LLP
(86) International application number: PCT/KR2023/016747
(87) International publication number: WO 2024/154903

(57) **Abstract**

This display device comprises: a plurality of display modules; and a frame that supports the plurality of display modules so that the plurality of display modules are horizontally arranged in an M×N matrix form. The frame comprises: a module attachment layer to which the plurality of display modules are attached; a frame panel having a thermal expansion coefficient that is different from the thermal expansion coefficient of the module attachment layer; and a cushion layer provided between the frame panel and the module attachment layer to absorb an impact caused by the difference between the thermal strain rate of the module attachment layer and the thermal strain rate of the frame panel.

## Description

### [Technical Field]

The present disclosure relates to a display device for displaying an image by combining modules in which self-emissive light emitting elements are mounted on a substrate.

### [Background Art]

A display device is a type of output device that visually displays data information such as characters and figures, as well as images.

In general, a liquid crystal panel, which requires a backlight, or an organic light-emitting diode (OLED) panel formed of a film of organic compounds that emits light by itself in response to electric current, has been mainly used as the display device. However, the liquid crystal panel has a problem in that it is slow in response time, consumes a large amount of power, and is difficult to be compact due to the need for a backlight because it does not emit light by itself. In addition, although the OLED panel does not require a backlight because it emits light by itself and may be made thinner, it is vulnerable to the burn-in (deterioration) phenomenon in which a specific portion of a previous screen remains even after the screen is changed, as the lifespan of subpixels expires when the same screen is displayed for a long time.

Accordingly, as a new panel to replace the above, a micro light-emitting diode (microLED or µLED) display panel, in which inorganic light-emitting elements are mounted on a substrate and the inorganic light-emitting elements themselves are used as pixels, is being researched.

A micro light-emitting diode display panel (hereinafter, micro LED panel) is one of flat panel displays, and is composed of a plurality of inorganic light-emitting diodes (inorganic LEDs) each having a size of 100 micrometers or less.

Although this LED panels are also a self-emissive light-emitting element, they do not exhibit the burn-in phenomenon, which occurs in OLEDs, because they are inorganic light-emitting elements. Therefore, the LED panels shows excellent luminance, resolution, power consumption, and durability.

Compared to a liquid crystal display (LCD) panel that requires a backlight, the microLED display panel provides better contrast, response time, and energy efficiency. Although both organic LEDs and microLEDs, which are inorganic light-emitting elements have good energy efficiency, microLEDs have greater brightness, higher luminous efficiency, and longer lifespan than OLEDs.

In addition, by arranging LEDs on a circuit board on a pixel basis, it is possible to manufacture display modules on a substrate basis, and it is easy to manufacture in various resolutions and screen sizes according to customer orders.

### [Disclosure]

### [Technical Problem]

An embodiment of the present disclosure provides a display device with improved reliability.

An embodiment of the present disclosure provides a display device with an improved manufacturing process.

An embodiment of the present disclosure provides a display device with an improved structure.

Technical problems to be solved by this document are not limited to the above-mentioned technical problems, and other technical problems, which are not mentioned above, may be clearly understood from the following descriptions by those skilled in the art to which the present disclosure pertains.

### [Technical Solution]

According to the spirit of the present disclosure, the display device includes a plurality of display modules, and a frame that supports the plurality of display modules such that the plurality of display modules are horizontally arranged in an M×N matrix form. The frame includes a module attachment layer to which the plurality of display modules are attached, a frame panel having a thermal expansion coefficient that is different from a thermal expansion coefficient of the module attachment layer, and a cushion layer provided between the frame panel and the module attachment layer, the cushion layer being provided to absorb impact due to a difference between a thermal strain rate of the module attachment layer and a thermal strain rate of the frame panel.

According to the spirit of the present disclosure, the display device includes a plurality of display modules, and a frame that supports the plurality of display modules such that the plurality of display modules are horizontally arranged in an M×N matrix form. The frame includes a frame panel, a module attachment layer to which the plurality of display modules are attached, the module attachment layer having a thermal expansion coefficient more similar to a thermal expansion coefficient of the plurality of display modules than to a thermal expansion coefficient of the frame panel, a cushion layer provided between the frame panel and the module attachment layer, the cushion layer being provided to have greater flexibility than flexibility of the module attachment layer and flexibility of the frame panel, and a frame chassis disposed on a side opposite to one side where the module attachment layer of the frame panel is disposed.

### [Description of Drawings]

FIG. 1 illustrates a display device according to an embodiment.
FIG. 2 illustrates an exploded view of main components of the display device according to an embodiment.
FIG. 3 illustrates an enlarged cross-sectional view of some components of a display module of the display device according to an embodiment.
FIG. 4 illustrates a rear view of a display module of the display device according to an embodiment.
FIG. 5 illustrates an exploded view of a frame of the display device according to an embodiment.
FIG. 6 illustrates an exploded view of components mounted on a frame of the display device according to an embodiment.
FIG. 7 illustrates a cross-sectional view of a cushion layer of the frame according to an embodiment.
FIG. 8 illustrates a cross-sectional view of a cushion layer of the frame according to an embodiment.

### [Modes of the Invention]

Various embodiments of this document and the terms used in the embodiments are not intended to limit the technical features disclosed in this document to the particular embodiments and should be understood as including various alterations, equivalents, or alternatives of the corresponding embodiments.

In connection with the description of the drawings, the similar reference numerals may be used for the similar or relevant constituent elements.

The singular form of a noun corresponding to an item may include one or plurality of the items, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases.

The term "and/or" includes a combination of a plurality of related constituent elements or any constituent element among the plurality of related constituent elements.

Such terms as "1st" and "2nd," or "first" and "second" may be used to simply distinguish a corresponding constituent element from another, and does not limit the constituent elements in other aspect (e.g., importance or order).

When a constituent element (e.g., a first constituent element) is referred to, with or without the term "operatively" or "communicatively," as "coupled with," "coupled to," "connected with," or "connected to" another constituent element (e.g., a second constituent element), it means that the constituent element may be coupled with the other constituent element directly (e.g., wiredly), wirelessly, or via a third constituent element.

It should be understood the terms "comprises," "comprising," "includes," "including," "containing," "has," "having" or other variations thereof are inclusive and therefore specify the presence of stated features, integers, steps, operations, elements, components, or combinations thereof disclosed in this document, but do not preclude the presence or addition of one or more other features, integers, steps, operations, elements, components, or combinations thereof.

When a constituent element is said to be "connected," "coupled," "supported," or "in contact" with another constituent element, this includes not only cases where the constituent elements are directly connected, coupled, supported, or in contact with each other, but also cases where they are indirectly connected, coupled, supported, or in contact through a third constituent element.

When a constituent element is said to be positioned "on" another constituent element, this includes not only cases where the constituent element is in direct contact with the other constituent element, but also cases where another constituent element exists between the two constituent elements.

Hereinafter, preferred embodiments according to the present disclosure will be described in detail with reference to the accompanying drawings.

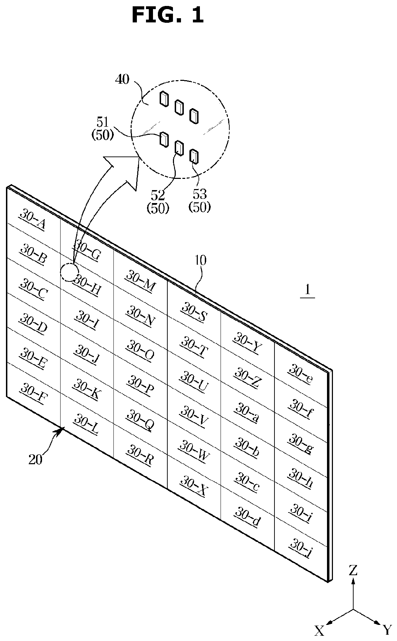

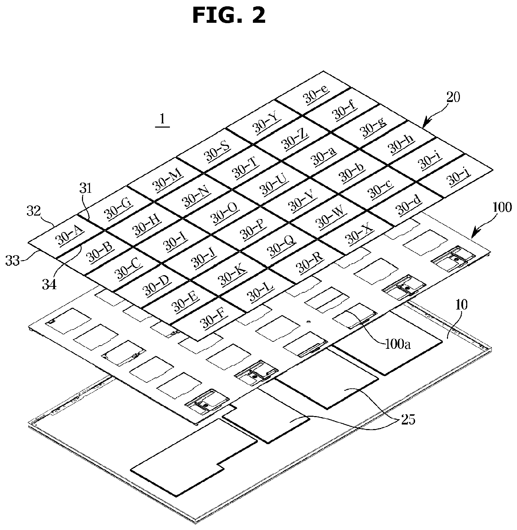

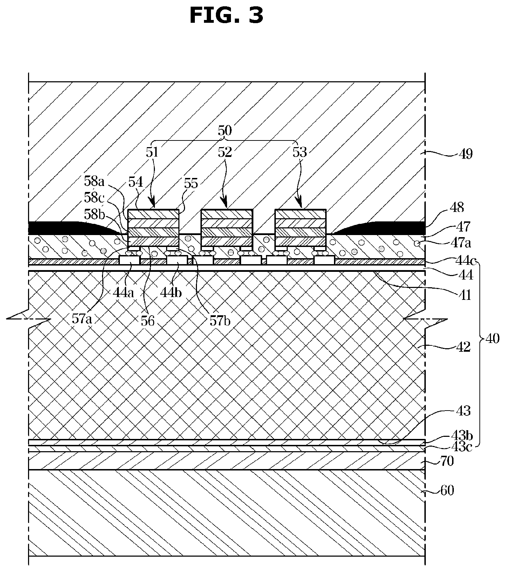

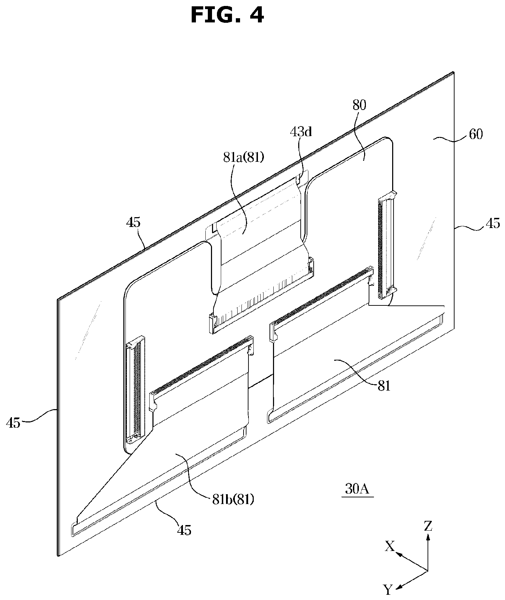

FIG. 1 illustrates a display device according to an embodiment. FIG. 2 illustrates an exploded view of main components of the display device according to an embodiment. FIG. 3 illustrates an enlarged cross-sectional view of some components of a display module of the display device according to an embodiment. FIG. 4 illustrates a rear view of a display module of the display device according to an embodiment.

Some components of a display device 1, including a plurality of inorganic light-emitting elements 50 illustrated in the drawings, are micro-scale components having sizes ranging from several micrometers to several hundreds of micrometers, and for convenience of description, the scales of some components (the plurality of inorganic light-emitting elements 50, a black matrix 48, etc.) are exaggerated in the drawings.

The display device 1 is a device for displaying information, materials, data, etc. as characters, figures, graphs, images, and the like, and TVs, PCs, mobile devices, digital signage, and the like may be implemented as the display device 1.

According to an embodiment of the present disclosure, as illustrated in FIG. 1 and FIG. 2, the display device 1 may include a display panel 20 for displaying images, a board 25 for driving and/or controlling the display panel 20, a frame 100 for supporting the display panel 20, and a rear cover 10 covering the rear surface of the frame 100.

The display panel 20 may include a plurality of display modules 30A to 30j, a driving board for driving each of the display modules 30A to 30j, and a timing controller board (TOCN board) for generating timing signals required for control of each of the display modules 30A to 30j.

The board 25 may include a circuit board for driving and/or controlling the display device 1. As an example, the board 25 may include at least one of a power board for supplying power to the display panel 20, a control board for controlling an overall operation of the display panel 20, or a communication board for communication with an external device.

The rear cover 10 may support the display panel 20. The rear cover 10 may be installed on a floor through a stand (not illustrated), or may be installed on a wall through a hanger (not illustrated) or the like.

A plurality of display modules 30A to 30j may be arranged adjacent to each other in up and down and left and right directions. The plurality of display modules 30A to 30j may be arranged in a M×N matrix form. In this embodiment, the plurality of display modules 30A to 30j are provided with thirty-six modules and are arranged in a 6×6 matrix form, but the number and arrangement manner of the display modules 30A to 30j are not limited thereto.

The plurality of display modules 30A to 30j may be installed on the frame 100. The plurality of display modules 30A to 30j may be installed on the frame 100 by various known methods such as magnetic force using magnets, mechanical fitting structures, or adhesion. The rear cover 10 is coupled to the rear side of the frame 100, and the rear cover 10 may form a rear exterior of the display device 1. The frame 100 may include a plurality of module openings 100a formed to correspond to the plurality of display modules 30A to 30j.

The rear cover 10 may include a metal material. Accordingly, heat generated from the plurality of display modules 30A to 30j and the frame 100 may be easily conducted to the rear cover 10, thereby improving a heat dissipation efficiency of the display device 1.

The display device 1 according to various embodiments may implement a large screen by tiling the plurality of display modules 30A to 30j.

Unlike the embodiment of the present disclosure, in the plurality of display modules 30A to 30j, each individual display module may be applied to a display device. That is, the display modules 30A to 30j may be installed and applied, as individual units, to wearable devices, portable devices, handheld devices, and various electronic products or electronic components that require a display, and may also be applied to display devices such as monitors for personal computers (PCs), high-definition TVs, signage, and electronic displays, through a matrix-type plurality of assembled arrangements as in the embodiment of the present disclosure.

The plurality of display modules 30A to 30j may have the same configuration with one another. Accordingly, the description of any one of the display modules described below may be equally applied to all other display modules.

Among the plurality of display modules 30A to 30j, a first display module 30A, as an example, may be formed in a quadrangle type. The first display module 30A may be provided in a rectangle type shape or a square type shape.

Accordingly, the first display module 30A may include edges 31, 32, 33, and 34 that are formed in up, down, left, and right directions based on a first direction X corresponding to the frontward direction.

As illustrated in FIG. 3, the plurality of display modules 30A to 30j may each include a substrate 40 and a plurality of inorganic light-emitting elements 50 mounted on the substrate 40. The plurality of inorganic light-emitting elements 50 may be mounted on a mounting surface 41 of the substrate 40 that faces the first direction X. In FIG. 3, for convenience of explanation, the thickness of the substrate 40 in the first direction X is illustrated exaggeratedly thick.

The substrate 40 may be formed in a quadrangle type. As described above, the plurality of display modules 30A to 30j may each be provided in a quadrangle type shape, and the substrate 40 may be formed in a quadrangle type corresponding thereto.

The substrate 40 may be provided in a rectangle type shape or a square type shape.

Accordingly, using the first display module 30A as an example, the substrate 40 may include four edges corresponding to edges 31, 32, 33, and 34 of the first display module 30A, which are formed in up, down, left, and right directions based on the first direction X corresponding to the frontward direction.

The substrate 40 may include a base substrate 42, a mounting surface 41 forming one surface of the base substrate 42, a rear surface 43 disposed on the opposite side of the mounting surface 41 and forming the other surface of the base substrate 42, and a side surface 45 disposed between the mounting surface 41 and the rear surface 43.

The substrate 40 may include a thin film transistor (TFT) layer 44 formed on the base substrate 42 to drive the inorganic light-emitting elements 50. The base substrate 42 may include a glass substrate. That is, the substrate 40 may include a chip-on-glass (COG) type substrate. The substrate 40 may have first and second pad electrodes 44a and 44b formed to be provided such that the inorganic light-emitting elements 50 are electrically connected to the TFT layer 44.

The thin film transistor (TFT) constituting the TFT layer 44 may not be limited to a specific structure or type, and may be configured in various embodiments. That is, the TFT of the TFT layer 44 according to an embodiment may be implemented not only as a low temperature poly silicon (LTPS) TFT, oxide TFT, or Si (poly silicon or a-silicon) TFT, but also as an organic TFT, a graphene TFT, and the like.

In addition, when the base substrate 42 of the substrate 40 is provided as a silicon wafer, the TFT layer 44 may be replaced with a complementary metal-oxide semiconductor (CMOS) type transistor, or an n-type MOSFET or p-type MOSFET transistor.

The plurality of inorganic light-emitting elements 50 may be formed of inorganic material, and may include inorganic light-emitting elements having widths, lengths, and heights each in the range of several micrometers to several tens of micrometers. A micro inorganic light-emitting element may have, among the width, length, and height, a shortest side length of 100 µm or less. That is, the inorganic light-emitting element 50 may be picked up from a wafer formed of sapphire or silicon material and may be directly transferred onto the substrate 40. The plurality of inorganic light-emitting elements 50 may be picked up and transferred by an electrostatic method using an electrostatic head, or by a stamp method using a head formed of an elastic polymer material such as PDMS or silicon.

The plurality of inorganic light-emitting elements 50 may be light-emitting structures including an n-type semiconductor 58a, an active layer 58c, a p-type semiconductor 58b, a first contact electrode 57a, and a second contact electrode 57b.

Although not illustrated in the drawings, one of the first contact electrode 57a or the second contact electrode 57b may be provided to be electrically connected to the n-type semiconductor 58a, and the other may be provided to be electrically connected to the p-type semiconductor 58b.

The first contact electrode 57a and the second contact electrode 57b may be disposed horizontally, and may be in a flip chip form disposed to face the same direction (a direction opposite to a light-emitting direction).

When the inorganic light-emitting element 50 is mounted on the mounting surface 41, it may have a light-emitting surface 54 disposed to face the first direction X, a side surface 55, and a bottom surface 56 disposed on the opposite side of the light-emitting surface 54, and the first contact electrode 57a and the second contact electrode 57b may be formed on the bottom surface 56.

That is, the contact electrodes 57a and 57b of the inorganic light-emitting element 50 may be disposed on a side opposite to the light-emitting surface 54, and accordingly, may be disposed on a side opposite to a direction in which light is emitted.

The contact electrodes 57a and 57b may be disposed to face the mounting surface 41, may be provided to be electrically connected to the TFT layer 44, and the light-emitting surface 54 that emits light may be disposed in a direction opposite to the direction in which the contact electrodes 57a and 57b are disposed.

Accordingly, when light generated from the active layer 58c is emitted in the first direction X through the light-emitting surface 54, the light may be emitted toward the first direction X without interference from the first contact electrode 57a or the second contact electrode 57b.

That is, the first direction X may be defined as a direction in which the light-emitting surface 54 is disposed to emit light.

The first contact electrode 57a and the second contact electrode 57b may be electrically connected to a first pad electrode 44a and a second pad electrode 44b, respectively, which are formed on the mounting surface 41 side of the substrate 40.

The inorganic light-emitting element 50 may be directly connected to the pad electrodes 44a and 44b through a bonding structure such as an anisotropic conductive layer 47 or solder.

The anisotropic conductive layer 47 may be formed on the substrate 40 to mediate electrical bonding between the contact electrodes 57a and 57b and the pad electrodes 44a and 44b. The anisotropic conductive layer 47 may be an anisotropic conductive adhesive attached to a protective film, and may have a structure in which conductive balls 47a are dispersed in an adhesive resin. The conductive balls 47a may be conductive spheres surrounded by a thin insulating film, and may electrically connect conductors to each other as the insulating film is broken by pressure.

The anisotropic conductive layer 47 may include an anisotropic conductive film (ACF) in a film form and an anisotropic conductive paste (ACP) in a paste form.

Accordingly, when the plurality of inorganic light-emitting elements 50 are mounted on the substrate 40, in case that pressure is applied to the anisotropic conductive layer 47, the insulating film of the conductive balls 47a may be broken, so that the contact electrodes 57a and 57b of the inorganic light-emitting element 50 may be electrically connected to the pad electrodes 44a and 44b of the substrate 40.

However, although not illustrated in the drawings, the plurality of inorganic light-emitting elements 50 may be mounted on the substrate 40 through solder (not illustrated) instead of the anisotropic conductive layer 47. After the inorganic light-emitting element 50 is aligned on the substrate 40, the inorganic light-emitting element 50 may be bonded to the substrate 40 through a reflow process.

The plurality of inorganic light-emitting elements 50 may include a red light-emitting element 51, a green light-emitting element 52, and a blue light-emitting element 53, and the light-emitting elements 50 may be mounted on the mounting surface 41 of the substrate 40 as a unit including a set of the red light-emitting element 51, the green light-emitting element 52, and the blue light-emitting element 53. The set of the red light-emitting element 51, the green light-emitting element 52, and the blue light-emitting element 53 may form one pixel. In this case, the red light-emitting element 51, the green light-emitting element 52, and the blue light-emitting element 53 may each form a sub pixel.

As an example, the red light-emitting element 51, the green light-emitting element 52, and the blue light-emitting element 53 may be disposed in a row at predetermined intervals, or may be disposed in other forms such as a triangular shape.

The substrate 40 may include a light absorbing layer 44c so as to absorb external light to enhance contrast. The light absorbing layer 44c may be formed on the entire mounting surface 41 side of the substrate 40. The light absorbing layer 44c may be formed between the TFT layer 44 and the anisotropic conductive layer 47.

The plurality of display modules 30A to 30j may further include a black matrix 48 formed between the plurality of inorganic light-emitting elements 50.

The black matrix 48 may perform a function of supplementing the light absorbing layer 44c formed entirely on the mounting surface 41 side of the substrate 40. That is, the black matrix 48 may improve the contrast of the screen by absorbing external light and causing the substrate 40 to appear black.

The black matrix 48 may preferably have a black color.

In this embodiment, the black matrix 48 is formed to be disposed between pixels formed by a set of red light-emitting elements 51, green light-emitting elements 52, and blue light-emitting elements 53. However, unlike this embodiment, the black matrix 48 may also be more finely formed to partition each of the light-emitting elements 51, 52, and 53, which are sub pixels.

The black matrix 48 may be formed in a grid shape having a horizontal pattern and a vertical pattern so as to be disposed between the pixels.

The black matrix 48 may be formed by applying light absorbing ink on the anisotropic conductive layer 47 through an ink-jet process and curing the ink, or by coating a light absorbing film on the anisotropic conductive layer 47.

That is, in the anisotropic conductive layer 47 formed entirely on the mounting surface 41, the black matrix 48 may be formed between the plurality of inorganic light-emitting elements 50 in which the plurality of inorganic light-emitting elements 50 are not mounted.

Each of the plurality of display modules 30A to 30j may include a front cover 49 disposed on the mounting surface 41 in the first direction X to cover the mounting surface 41 of each of the plurality of display modules 30A to 30j.

The front cover 49 may be provided in plurality so as to be respectively formed on the plurality of display modules 30A to 30j in the first direction X.

The front cover 49 may include a film (not illustrated).

The film (not illustrated) of the front cover 49 may be provided as a functional film having optical performance.

The front cover 49 may be provided to cover the substrate 40 so as to protect the substrate 40 from external force.

Typically, an adhesive layer (not illustrated) of the front cover 49 may be provided to have a height of a predetermined level or more in the first direction X, which is a direction in which the mounting surface 41 or the light-emitting surface 54 faces. This is to sufficiently fill a gap that may be formed between the front cover 49 and the plurality of inorganic light-emitting elements 50 when the front cover 49 is disposed on the substrate 40.

Each of the plurality of display modules 30A to 30j may include a heat dissipation member 60 provided on the rear surface 43 of the substrate 40 to dissipate heat generated in the substrate 40.

The heat generated in the substrate 40 may include heat generated from various components. Among the heat generated in the substrate 40 and transferred to the rear surface 43, the heat that accounts for the largest proportion may be heat generated when the plurality of inorganic light-emitting elements 50 emit light. However, in addition to this, heat may also be generated from a plurality of components disposed on the mounting surface 41 of the substrate 40, such as the TFT layer 44, and the heat generated from the plurality of components may be introduced into the substrate 40.

In addition, heat may be transferred from the outside of the substrate 40 to the substrate 40, and heat may be transferred to the substrate 40 through components outside the substrate 40, thereby causing heat to be generated in the substrate 40.

Hereinafter, the heat generated in the substrate 40 refers to heat that is introduced into the substrate 40 from heat that is actually generated in a plurality of components disposed on the substrate 40 including the plurality of inorganic light-emitting elements 50.

Specifically, as described above, the heat generated from the plurality of inorganic light-emitting elements 50 is most introduced into the substrate 40, and accordingly, the largest proportion of the heat generated in the substrate 40 is heat generated from the plurality of inorganic light-emitting elements 50. However, as described above, it may be expressed that heat is generated in the substrate 40 due to heat generated from various components and from outside the substrate 40 in addition to the plurality of inorganic light-emitting elements 50. In addition, each of the plurality of display modules 30A to 30j may include an adhesive tape 70 that is disposed between the rear surface 43 of the substrate 40 and the heat dissipation member 60 so as to adhere the rear surface 43 and the heat dissipation member 60.

The plurality of inorganic light-emitting elements 50 may be electrically connected to an upper wiring layer (not illustrated), which is formed as a pixel driving wiring (not illustrated) that is formed on the mounting surface 41 and extended through the side surface 45 of the substrate 40.

The upper wiring layer (not illustrated) may be electrically connected to a side wiring (not illustrated) formed on the side surface 45 of the substrate 40. The side wiring (not illustrated) may be provided in a thin film form.

The upper wiring layer (not illustrated) may be connected to the side wiring (not illustrated) by an upper connection pad (not illustrated) formed on an edge side of the substrate 41.

The side wiring (not illustrated) may be extended along the side surface 45 of the substrate 40 and may be connected to a rear wiring layer 43b formed on the rear surface 43.

On the rear wiring layer 43b, in the direction toward the rear side of the substrate 40, an insulating layer 43c covering the rear wiring layer 43b may be formed.

That is, the plurality of inorganic light-emitting elements 50 may be sequentially electrically connected to the upper wiring layer (not illustrated), the side wiring (not illustrated), and the rear wiring layer 43b.

In addition, as illustrated in FIG. 4, the display module 30A may include a driving circuit board 80 that is provided to electrically control the plurality of inorganic light-emitting elements 50 mounted on the mounting surface 41. The driving circuit board 80 may be formed as a printed circuit board. The driving circuit board 80 may be disposed on the rear surface 43 of the substrate 40 in the first direction X. The driving circuit board 80 may be disposed on the heat dissipation member 60 that is adhered to the rear surface 43 of the substrate 40.

The display module 30A may include a flexible film 81 that connects the driving circuit board 80 and the rear wiring layer 43b so that the driving circuit board 80 is electrically connected to the plurality of inorganic light-emitting elements 50.

One end of the flexible film 81 may be disposed on the rear surface 43 of the substrate 40 and may be connected to a rear connection pad 43d that is electrically connected to the plurality of inorganic light-emitting elements 50.

The rear connection pad 43d may be electrically connected to the rear wiring layer 43b. Accordingly, the rear connection pad 43a may electrically connect the rear wiring layer 43b and the flexible film 81.

As the flexible film 81 is electrically connected to the rear connection pad 43d, power and electrical signals may be transmitted from the driving circuit board 80 to the plurality of inorganic light-emitting elements 50.

The flexible film 81 may be formed as a flexible flat cable (FFC), a chip on film (COF), or the like.

The flexible film 81 may include a first flexible film 81a and a second flexible film 81b that are respectively disposed in up and down directions with respect to the first direction X, which is the frontward direction.

The first flexible film 81a and the second flexible film 81b are not limited thereto, and may be disposed in left and right directions with respect to the first direction X, or may be respectively disposed in at least two directions of up, down, left, or right directions.

The second flexible film 81b may be provided in plurality. However, the present disclosure is not be limited thereto and the second flexible film 81b may be provided as a single piece, and the first flexible film 81a may also be provided in plurality.

The first flexible film 81a may transmit data signals from the driving circuit board 80 to the substrate 40. The first flexible film 81a may be provided as COF.

The second flexible film 81b may transmit power from the driving circuit board 80 to the substrate 40. The second flexible film 81b may be provided as FFC.

However, the present disclosure is not limited thereto and the first flexible film 81a and the second flexible film 81b may be formed in reverse to each other.

Although not illustrated in the drawings, the driving circuit board 80 may be electrically connected to the main board 25 (see FIG. 2). The board 25 may be disposed on a rear side of the frame 100, and the board 25 may be connected to the driving circuit board 80 from the rear side of the frame 100 through a cable (not illustrated).

As described above, the heat dissipation member 60 may be provided to be in contact with the substrate 40. The substrate 40 and the heat dissipation member 60 may be adhered to each other by the adhesive tape 70 disposed between the rear surface 43 of the substrate 40 and the heat dissipation member 60.

The heat dissipation member 60 may be formed of a material having high thermal conductivity or may be implemented as a configuration having high thermal conductivity. For example, the heat dissipation member 60 may be provided as a graphite sheet. For example, the heat dissipation member 60 may be provided as an aluminum material.

The heat generated in the plurality of inorganic light-emitting elements 50 and the TFT layer 44 mounted on the substrate 40 may be transferred to the heat dissipation member 60 through the adhesive tape 70 along the rear surface 43 of the substrate 40.

Accordingly, heat generated in the substrate 40 may be easily transferred to the heat dissipation member 60, and it may be possible to prevent the substrate 40 from rising above a predetermined temperature.

The plurality of display modules 30A to 30j may be arranged at various positions in an M×N matrix form, respectively. Each of the display modules 30A to 30j may be provided to be individually movable. In this case, each of the display modules 30A to 30j may individually include the heat dissipation member 60 so that each of the display modules 30A to 30j may maintain a predetermined level of heat dissipation performance regardless of the position at which each of the display modules 30A to 30j is disposed.

The plurality of display modules 30A to 30j may form screens of various sizes of the display device 1 in various M×N matrix forms. Accordingly, compared to heat dissipation through a single heat dissipation member provided for the heat dissipation of the entire plurality of display modules 30A to 30j, the configuration in which each of the display modules 30A to 30j includes an independent heat dissipation member 60 and individually dissipates heat, as in an embodiment of the present disclosure, may improve the overall heat dissipation performance of the display device 1.

When a single heat dissipation member is disposed inside the display device 1, a portion of the heat dissipation member may not be disposed at a position corresponding to a position where some display modules are disposed with respect to the front-rear direction, and the heat dissipation member may be disposed at a position where no display module is disposed, thereby degrading the heat dissipation efficiency of the display device 1.

That is, through the heat dissipation member 60 disposed in each of the display modules 30A to 30j, all of the display modules 30A to 30j may individually dissipate heat by the respective heat dissipation member 60 regardless of the position where each of the display modules 30A to 30j is disposed, thereby improving the overall heat dissipation performance of the display device 1.

The heat dissipation member 60 may be provided in a quadrangle type shape corresponding approximately to the shape of the substrate 40.

The area of the substrate 40 may be provided to be at least equal to or greater than the area of the heat dissipation member 60. When the substrate 40 and the heat dissipation member 60 are disposed in parallel in the first direction X, the four edges of the rectangular-shaped substrate 40 may be formed to correspond to the four edges of the heat dissipation member 60 with respect to the center of the substrate 40 and the heat dissipation member 60, or may be provided to be disposed further outward than the four edges of the heat dissipation member 60 with respect to the center of the substrate 40 and the heat dissipation member 60.

Preferably, the four edges of the substrate 40 may be provided to be disposed further outward than the four edges of the heat dissipation member 60. That is, the area of the substrate 40 may be provided to be greater than the area of the heat dissipation member 60.

This is because, when heat is transferred to each of the display modules 30A to 30j, the substrate 40 and the heat dissipation member 60 may undergo thermal expansion, and the heat dissipation member 60 may have a higher thermal expansion rate than the substrate 40, such that the expansion value of the heat dissipation member 60 may be greater than that of the substrate 40.

**In** this case, when the four edges of the substrate 40 correspond to or are disposed more inward than the four edges of the heat dissipation member 60, the edges of the heat dissipation member 60 may protrude outward from the substrate 40.

Accordingly, a spacing distance of a gap formed between the respective display modules 30A to 30j may be irregularly formed due to the thermal expansion of the heat dissipation members 60 of the respective modules 30A to 30j, and as a result, recognition of some seams may increase, thereby degrading the sense of unity of the screen of the display panel 20.

However, when the four edges of the substrate 40 are provided to be disposed outward than the four edges of the heat dissipation member 60, the heat dissipation member 60 may not protrude outward beyond the four edges of the substrate 40 even if thermal expansion occurs in the substrate 40 and the heat dissipation member 60, and accordingly, the spacing distance of the gap formed between the respective display modules 30A to 30j may be maintained uniformly.

According to an embodiment of the present disclosure, the area of the substrate 40 and the area of the heat dissipation member 60 may be provided to approximately correspond to each other. Accordingly, heat generated in the substrate 40 may be uniformly dissipated over the entire region of the substrate 40 without being confined to a partial region.

The heat dissipation member 60 may be provided to be adhered to the rear surface 43 of the substrate 40 by the adhesive tape 70.

The adhesive tape 70 may be provided in a size corresponding to the heat dissipation member 60. That is, the area of the adhesive tape 70 may be provided to correspond to the area of the heat dissipation member 60. The heat dissipation member 60 may be provided in an approximately quadrangle type shape, and the adhesive tape 70 may be provided in a quadrangle type shape corresponding thereto.

With respect to the center of the heat dissipation member 60 and the adhesive tape 70, the edges of the rectangular heat dissipation member 60 and the edges of the adhesive tape 70 may be formed to correspond to each other.

Accordingly, the heat dissipation member 60 and the adhesive tape 70 may be easily manufactured as a single combined configuration, thereby improving the manufacturing efficiency of the overall display device 1.

That is, when the heat dissipation member 60 is cut into unit pieces from a single plate, the adhesive tape 70 may be pre-adhered to the plate before the heat dissipation member 60 is cut, and the adhesive tape 70 and the heat dissipation member 60 may be simultaneously cut into unit pieces, thereby resulting in an effect of reducing the number of processes.

Heat generated in the substrate 40 may be transferred to the heat dissipation member 60 through the adhesive tape 70. Accordingly, the adhesive tape 70 may be provided to adhere the heat dissipation member 60 to the substrate 40 and simultaneously to transfer heat generated in the substrate 40 to the heat dissipation member 60.

Therefore, the adhesive tape 70 may include a material having high heat dissipation performance.

The adhesive tape 70 may include a material having adhesiveness for adhering the substrate 40 and the heat dissipation member 60.

The adhesive tape 70 may include a material having higher heat dissipation performance than a material having material general adhesiveness. Accordingly, heat may be efficiently transferred to respective components between the substrate 40 and the heat dissipation member 60.

In addition, the material having adhesiveness of the adhesive tape 70 may be formed of a material having higher heat dissipation performance than that of adhesive materials forming general adhesives.

A material having high heat dissipation performance refers to a material having high thermal conductivity, high thermal transferability, and low specific heat, thereby enabling effective heat transfer.

For example, the adhesive tape 70 may include a graphite material. However, the present disclosure is not limited thereto and the adhesive tape 70 may be generally provided as a material having high heat dissipation performance.

The flexibility of the adhesive tape 70 may be provided to be greater than the flexibility of the substrate 40 and the flexibility of the heat dissipation member 60. Therefore, the adhesive tape 70 may be provided as a material having high flexibility, while also having adhesiveness and heat dissipation property. The adhesive tape 70 may be formed as a double-sided tape using inorganic base material. The adhesive tape 70 may be formed as a double-sided tape using an inorganic base material, such that between one surface adhered to the substrate 40 and the other surface adhered to the heat dissipation member 60, the adhesive tape 70 may be formed as a single layer without a base material that supports the one surface and the other surface.

Because the adhesive tape 70 does not include a base material, it does not include a material that interferes with thermal conduction, and thus heat dissipation performance may be improved. However, the adhesive tape 70 may not be limited to a double-sided tape using inorganic base material, and may be provided as a heat dissipation tape having better heat dissipation performance than that of a general double-sided tape.

For example, when the substrate 40 is configured to include a glass material and the heat dissipation member 60 is configured to include a metal material, the degree of material deformation caused by the same heat may differ due to differences in material properties of each component. That is, when heat is generated in the substrate 40, the substrate 40 and the heat dissipation member 60 may each be thermally expanded in size differently due to the heat. Accordingly, a problem may occur in which the display module 30A is damaged.

This is because, in a state where the substrate 40 and the heat dissipation member 60 are fixed to each other, since the expansion values of the substrate 40 and the heat dissipation member 60 at the same temperature are different, stress may occur in each component as the substrate 40 and the heat dissipation member 60 expand to different sizes.

Among the material properties, particularly, because the thermal expansion coefficients of the respective materials are different, the degree of physical deformation of the material caused by heat may differ, and especially, because the thermal expansion coefficient of a metal material is generally greater than that of glass, the heat dissipation member 60 may be expanded and deformed more than the substrate 40 when the same heat is transmitted to the substrate 40 and the heat dissipation member 60.

In contrast, when the generation of heat in the substrate 40 ends and the substrate 40 and the heat dissipation member 60 are respectively cooled, the heat dissipation member 60 may be contracted and deformed more than the substrate 40.

Because the substrate 40 and the heat dissipation member 60 are in a state of being adhered to each other by the adhesive tape 70, when the heat dissipation member 60 is deformed more than the substrate 40, external force may be transmitted to the substrate 40.

Conversely, external force may also be transmitted to the heat dissipation member 60 by the substrate 40, but because the stiffness of the substrate 40 made of glass is lower than the stiffness of the heat dissipation member 60 made of metal, the substrate 40 may be broken.

The adhesive tape 70 may be provided to absorb external force transmitted from different components as the substrate 40 and the heat dissipation member 60 expand to different sizes between the substrate 40 and the heat dissipation member 60.

Accordingly, external force transmitted to the substrate 40 and the heat dissipation member 60, particularly breakage of the substrate 40, may be prevented.

In order to absorb external force transmitted from the substrate 40 and the heat dissipation member 60, the adhesive tape 70 may be provided as a material having higher flexibility. Specifically, the flexibility of the adhesive tape 70 may be provided to be greater than the flexibility of the substrate 40 and the flexibility of the heat dissipation member 60.

Accordingly, when external force generated by changes in the sizes of the substrate 40 and the heat dissipation member 60 is transmitted to the adhesive tape 70, the adhesive tape 70 itself may deform, thereby preventing the external force from being transmitted to the different components.

The adhesive tape 70 may have a predetermined thickness in the first direction X. When heat is transferred to the heat dissipation member 60 and it thermally expands, or when it is cooled and thermally contracted, the heat dissipation member 60 may be expanded or contracted not only in the first direction X but also in a direction orthogonal to the first direction X, and accordingly, external force may be transmitted to the substrate 40.

Hereinafter, the frame 100 according to an embodiment will be described in detail.

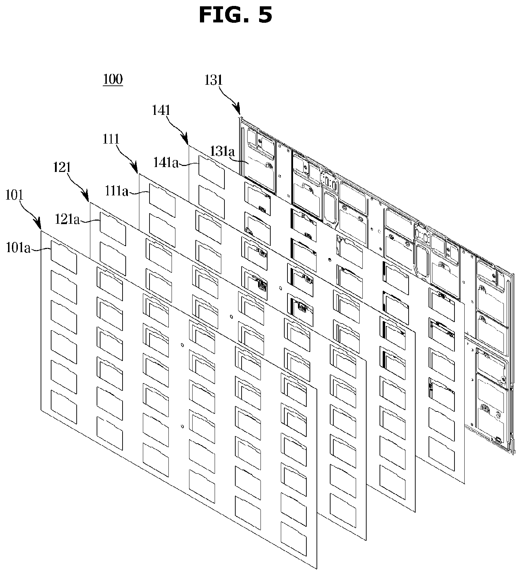

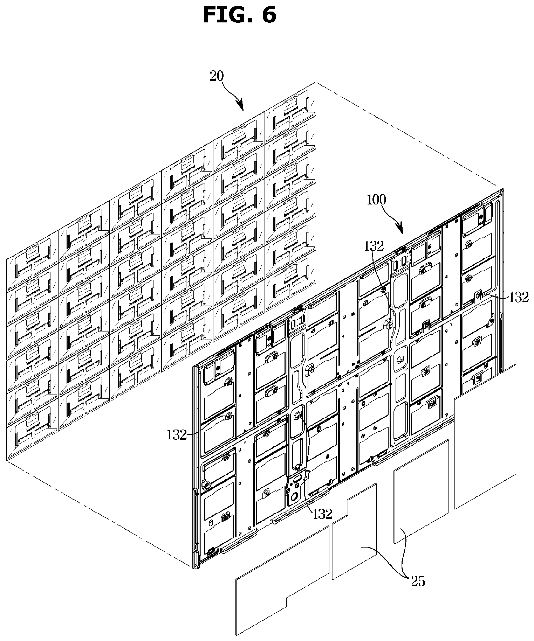

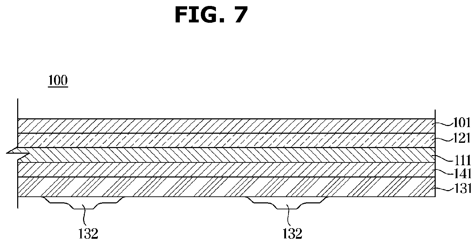

FIG. 5 illustrates an exploded view of a frame of the display device according to an embodiment. FIG. 6 illustrates an exploded view of components mounted on a frame of the display device according to an embodiment. FIG. 7 illustrates a cross-sectional view of a cushion layer of the frame according to an embodiment.

With reference to FIGS. 5 to 7, the frame 100 according to an embodiment may include a module attachment layer 101 to which the plurality of display modules 30A to 30j are attached. The module attachment layer 101 may have a thermal expansion coefficient more similar to the thermal expansion coefficient of the plurality of display modules 30A to 30j than to the thermal expansion coefficient of a frame panel 111. The module attachment layer 101 may include a material having the same or similar thermal expansion coefficient as the thermal expansion coefficient of the plurality of display modules 30A to 30j. The module attachment layer 101 may include carbon fiber reinforced plastics (CFRP).

As the module attachment layer 101 has the same or similar thermal expansion coefficient as the thermal expansion coefficient of the plurality of display modules 30A to 30j, the display device 1 according to an embodiment may prevent the plurality of display modules 30A to 30j from being damaged during deformation caused by heat. The display device 1 according to an embodiment may prevent the plurality of display modules 30A to 30j from being damaged, because the module attachment layer 101 may be deformed similarly to the plurality of display modules 30A to 30j while the plurality of display modules 30A to 30j are deformed by heat.

The display panel 20 may display a screen by the plurality of display modules 30A to 30j. In this case, due to seams formed by gaps formed between the plurality of display modules 30A to 30j, the unity of the screen may be degraded.

To minimize seam recognition in the display panel 20, the plurality of display modules 30A to 30j may be disposed on the frame 100 so as to form a uniform gap. This is because, when the gaps formed by the plurality of display modules 30A to 30j are not uniform, seam recognition caused by some gaps may be amplified.

The plurality of display modules 30A to 30j may be tiled on the frame 100. As the display device 1 is driven, the substrate 40 forming the plurality of display modules 30A to 30j may be thermally expanded due to heat generated in the display panel 20. Because material properties of the plurality of display modules 30A to 30j and the frame 100 are different, as the plurality of display modules 30A to 30j are thermally expanded to sizes different from the frame 100, widths between some of the gaps among the gaps between the plurality of display modules 30A to 30j may be irregularly formed, and seam recognition may be amplified.

The display device 1 according to an embodiment may prevent a gap between the plurality of display modules 30A to 30j from being irregularly formed, because a material property of the module attachment layer 101 of the frame 100 is provided to be the same as or similar to a material property of the plurality of display modules 30A to 30j.

The meaning that the material property of the module attachment layer 101 is formed to be similar to the material property of the plurality of display modules 30A to 30j may include the meaning that a thermal expansion coefficient, a specific heat, and a thermal conductivity of the plurality of display modules 30A to 30j are similar.

As the plurality of display modules 30A to 30j are adhered to the module attachment layer 101 in the first direction X, when the same heat is transferred to the plurality of display modules 30A to 30j and the module attachment layer 101 in a second direction Y and/or a third direction Z orthogonal to the first direction X, they may be provided to expand to corresponding lengths. When the substrate 40 of the plurality of display modules 30A to 30j is thermally expanded due to heat generated while the display device 1 according to an embodiment is driven, the module attachment layer 101 of the frame 100 may be thermally expanded to the same or similar value as the substrate 40.

As the module attachment layer 101 of the frame 100, which is a base surface to which the plurality of display modules 30A to 30j are adhered, is thermally expanded to the same or similar value as the substrate 40 of the plurality of display modules 30A to 30j, an interval of a gap formed between the plurality of display modules 30A to 30j may be maintained to be the same.

The display device 1 according to an embodiment may maintain a spacing distance of a gap formed between the plurality of display modules 30A to 30j to be the same as in a state in which the substrate 40 is not thermally expanded, so that a predetermined level of seam may be maintained and unity of the screen of the display panel 20 may be maintained.

Therefore, even when heat generated according to driving of the display device 1 is supplied to the substrate 40 of the plurality of display modules 30A to 30j, a phenomenon in which some seams are amplified and unity of the screen is degraded may be prevented, because a distance of a gap between the plurality of display modules 30A to 30k may be maintained to be uniform.

The module attachment layer 101 may include an opening 101a corresponding to the module opening 100a of the frame 100.

The frame 100 according to an embodiment may include the frame panel 111 disposed on one side of the module attachment layer 101. The frame panel 111 may be disposed at a rear side of the module attachment layer 101. The frame panel 111 may be positioned on a side opposite to one side of the module attachment layer 101 to which the plurality of display modules 30A to 30j are attached.

The frame 100 is a configuration provided to support the display panel 20, and may be provided to have stiffness equal to or greater than a predetermined level. The frame panel 111 may include a material having relatively high stiffness to secure the strength of the frame 100. The frame panel 111 may be provided to have greater stiffness than the module attachment layer 101. For example, the frame panel 111 may be formed of a metal material having a predetermined level of stiffness or more. For example, the frame panel 111 may be provided as a steel plate. For example, the frame panel 111 may include a stainless steel galvanized cold-rolled steel. For example, the frame panel 111 may include a steel electrogalvanized commercial cold-rolled (SECC).

A surface of the frame panel 111 facing the module attachment layer 101 may be formed flat without protruding portions. The frame panel 111 may be formed flat such that the plurality of display modules 30A to 30j may be horizontally arranged. The frame panel 111 may secure a flat plane for tiling the plurality of display modules 30A to 30j.

The frame panel 111 may have a thermal expansion coefficient different from the thermal expansion coefficient of the module attachment layer 101. The frame panel 111 may have a thermal expansion coefficient different from the thermal expansion coefficient of the plurality of display modules 30A to 30j. The frame panel 111 may have a thermal expansion coefficient smaller than the thermal expansion coefficient of the module attachment layer 101. The frame panel 111 may have a thermal expansion coefficient smaller than the thermal expansion coefficient of the plurality of display modules 30A to 30j.

The frame panel 111 may include an opening 111a corresponding to the module opening 100a of the frame 100.

The frame 100 according to an embodiment may include a cushion layer 121 provided between the module attachment layer 101 and the frame panel 111. The cushion layer 121 may be provided to absorb impacts resulting from a difference between the thermal strain rate of the module attachment layer 101 and the thermal strain rate of the frame panel 111 while both the module attachment layer 101 and the frame panel 111 are thermally deformed as heat is generated in the display device 1. The cushion layer 121 may be provided to compensate for a difference in thermal expansion coefficient between the module attachment layer 101 and the frame panel 111.

The cushion layer 121 may include a material having flexibility. The cushion layer 121 may be provided to have greater flexibility than the flexibility of the module attachment layer 101 and/or the flexibility of the frame panel 111. The cushion layer 121 may be configured to include a deformable material. The cushion layer 121 according to an embodiment may include a polyurethane foam (PU foam).

For example, during generation of heat in the display device 1, the thermal strain rate of the frame panel 111 may be greater than the thermal strain rate of the module attachment layer 101. While the frame panel 111 and the module attachment layer 101 are thermally deformed due to heat generated in the display device 1, the portion of the cushion layer 121 in contact with the frame panel 111 may be deformed more than the portion thereof in contact with the module attachment layer 101.

The module attachment layer 101 to which the plurality of display modules 30A to 30j are attached and the frame panel 111 may have different degrees of material deformation by the same heat, because material properties of the respective components are different. While heat is generated in the display device 1, the thermal strain rate of the frame panel 111 may be provided to be greater than the thermal strain rate of the module attachment layer 101. While heat is generated in the display device 1, the thermal strain rate of the frame panel 111 may be provided to be greater than the thermal strain rate of the plurality of display modules 30A to 30j.

Because values of deformation at the same temperature of the module attachment layer 101 to which the plurality of display modules 30A to 30j are attached and the frame panel 111 are different from each other, stress may be generated in each component as the module attachment layer 101 to which the plurality of display modules 30A to 30j are attached and the frame panel 111 are expanded to different sizes. Accordingly, the plurality of display modules 30A to 30j may be damaged.

For example, because the thermal expansion coefficient of the frame panel 111 is greater than the thermal expansion coefficient of the module attachment layer 101, the frame panel 111 may be expanded and deformed more than the module attachment layer 101 when the same heat is transferred to the module attachment layer 101 and the frame panel 111. For example, even when heat generation in the display device 1 ends and the module attachment layer 101 and the frame panel 111 are cooled, the frame panel 111 may be contracted and deformed more than the module attachment layer 101.

When the frame panel 111 is deformed more than the module attachment layer 101, external force may be transferred to the module attachment layer 101. Although an external force caused by the module attachment layer 101 may also be transferred to the frame panel 111, because the stiffness of the module attachment layer 101 and the plurality of display modules 30A to 30j is smaller than the stiffness of the frame panel 111, the module attachment layer 101 and the plurality of display modules 30A to 30j attached to the module attachment layer 101 may be damaged.

The cushion layer 121 may be provided to absorb external force transferred from different components as the module attachment layer 101 to which the plurality of display modules 30A to 30j are attached and the frame panel 111 are expanded to different sizes. The display device 1 according to an embodiment may prevent the module attachment layer 101 and the frame panel 111 from being subjected to external force, and particularly may prevent the module attachment layer 101 to which the plurality of display modules 30A to 30j are attached from being damaged.

As the cushion layer 121 is configured to include a material having flexibility, when external force generated from a size change of the module attachment layer 101 and the frame panel 111 is transferred to the cushion layer 121, it is possible to prevent the external force from being transferred to different components as the cushion layer 121 itself is deformed.

The cushion layer 121 may include an opening 121a corresponding to the module opening 100a of the frame 100.

The frame 100 according to an embodiment may include a frame chassis 131 disposed on a side opposite to one side of the frame panel 111 where the module attachment layer 101 is disposed. The frame chassis 131 may be disposed on a rear side of the frame panel 111.

With reference to FIG. 6, the frame chassis 131 may include a board mounting portion 132 formed to mount the board 25. The frame chassis 131, unlike the frame panel 111 that is formed to be flat, may have a structure formed to mount components such as various boards 25 of the display device 1. For example, the frame chassis 131 may include a material having stiffness such that the board mounting portion 132 for mounting the board 25 may be formed. The frame chassis 131 may be provided as a steel plate. The frame chassis 131 may include a material having stiffness such that components such as the board 25 of the display device 1 may be installed and supported.

In the display device 1 according to an embodiment, because the board mounting portion 132 for mounting the board 25 is formed in the frame chassis 131, a configuration such as a separate bracket and/or stud for mounting the board 25 to the frame 100 may be omitted.

The frame chassis 131 may include an opening 131a corresponding to the module opening 100a of the frame 100.

The frame 100 according to an embodiment may include a chassis adhesive layer 141 for attaching the frame chassis 131 to the frame panel 111. The chassis adhesive layer 141 may be provided as a double-sided tape. The chassis adhesive layer 141 may be formed as a double-sided tape using an inorganic base material. The chassis adhesive layer 141 may be formed as a single layer without a base layer between one surface thereof adhered to the frame panel 111 and the other surface thereof adhered to the frame chassis 131.

The chassis adhesive layer 141 may include an opening 141a corresponding to the module opening 100a of the frame 100.

The display device 1 according to an embodiment may secure flatness for tiling the plurality of display modules 30A to 30j by the frame panel 111, may prevent the plurality of display modules 30A to 30j from being thermally deformed and damaged by the module attachment layer 101 and the cushion layer 121, and may omit a separate structure for mounting components such as the board 25 by the frame chassis 131.

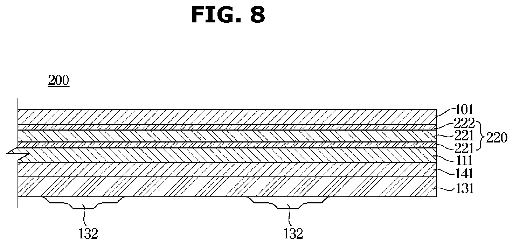

FIG. 8 illustrates a cross-sectional view of a cushion layer of the frame according to an embodiment.

With reference to FIG. 8, the cushion layer 220 of the frame 200 according to an embodiment will be described. In describing the cushion layer 220 of the frame 200 illustrated in FIG. 8, the same reference numerals will be assigned to components identical to those of the frame 100 illustrated in FIGS. 5 to 7, and detailed descriptions thereof may be omitted.

With reference to FIG. 8, the frame 200 may include the cushion layer 220 provided between the module attachment layer 101 and the frame panel 111. The cushion layer 220 may include a base layer 221, a first cushion adhesive layer 222 disposed on one side of the base layer 221, and a second cushion adhesive layer 223 disposed on a side opposite to the one side of the base layer 221. The cushion layer 220 may be provided as a double-sided tape having the base layer 221.

The base layer 221 may be provided to absorb impacts resulting from a difference between the thermal strain rate of the module attachment layer 101 and the thermal strain rate of the frame panel 111 while both the module attachment layer 101 and the frame panel 111 are thermally deformed as heat is generated in the display device 1.

The base layer 221 may include a material having flexibility. The base layer 221 may be provided to have greater flexibility than the flexibility of the module attachment layer 101 and/or the flexibility of the frame panel 111. The base layer 221 may be configured to include a deformable material. The base layer 221 according to an embodiment may include a foam.

As the base layer 221 is configured to include a material having flexibility, when external force generated from a size change of the module attachment layer 101 and the frame panel 111 is transferred to the base layer 221, it is possible to prevent the external force from being transferred to different components as the base layer 221 itself is deformed.

The first cushion adhesive layer 222 may be provided between the base layer 221 and the module attachment layer 101. The first cushion adhesive layer 222 may be provided to adhere the cushion layer 220 to the module attachment layer 101.

The second cushion adhesive layer 223 may be provided between the base layer 221 and the frame panel 111. The second cushion adhesive layer 223 may be provided to adhere the cushion layer 220 to the frame panel 111.

The frame 200 according to an embodiment may mitigate an impact that may be generated due to a difference in thermal expansion coefficient between the module attachment layer 101 and the frame panel 111, by a base layer 221 of the cushion layer 220.

The display device 1 according to an embodiment includes a plurality of display modules 30A to 30j, and frames 100 and 200 that supports the plurality of display modules so that the plurality of display modules are horizontally arranged in an M×N matrix form. The frame includes a module attachment layer 101 to which the plurality of display modules are attached, a frame panel 111 having a thermal expansion coefficient that is different from a thermal expansion coefficient of the module attachment layer, and a cushion layer provided between the frame panel and the module attachment layer, the cushion layer 121 or 220 being provided to absorb an impact caused by the module attachment layer and the frame panel being deformed to different sizes by heat. According to such a configuration, the display device 1 according to an embodiment may improve reliability because the cushion layer 121 or 220 may absorb an impact caused by a thermal strain rate difference between the module attachment layer 101 and the frame panel 111.

The module attachment layer may have a thermal expansion coefficient more similar to a thermal expansion coefficient of the plurality of display modules than to a thermal expansion coefficient of the frame panel. According to such a configuration, the display device 1 according to an embodiment may prevent the plurality of display modules 30A to 30j from being damaged while being deformed by heat.

The cushion layer may comprise a polyurethane foam.

The cushion layer 220 may include a base layer 221 including the foam, a first cushion adhesive layer 222 disposed on one side of the base layer and adhered to the module attachment layer, and a second cushion adhesive layer 222 disposed on a side opposite to the one side of the base layer and adhered to the frame panel.

The cushion layer may be provided to have flexibility greater than a flexibility of the module attachment layer and a flexibility of the frame panel. According to such a configuration, the display device 1 according to an embodiment may improve reliability because the cushion layer 121 or 220 may absorb an impact caused by a thermal strain rate difference between the module attachment layer 101 and the frame panel 111.

The frame panel may be provided to have stiffness greater than a stiffness of the module attachment layer. According to such a configuration, the display device 1 according to an embodiment may secure flatness of the frame 100 or 200 for tiling the plurality of display modules 30A to 30j.

The module attachment layer may comprise carbon fiber reinforced plastics (CFRP).

The frame panel may be provided as a steel plate.

The frame may comprise a frame chassis 131 disposed on a side opposite to one side of the frame panel where the module attachment layer is disposed.

The frame may comprise a chassis adhesive layer 141 for attaching the frame chassis to the frame panel.

The chassis adhesive layer may be provided as a double-sided tape.

The frame chassis may be provided as a steel plate.

The display device may further comprise a board 25, as a board mounted on the frame chassis, comprising at least one of a power board, a control board, or a communication board.

The frame chassis may comprise a board mounting portion 132 formed to mount the board. According to such a configuration, the display device 1 according to an embodiment may omit a separate bracket for mounting the board 25 to the frame 100 or 200, thereby improving a manufacturing process.

The display device 1 according to an embodiment includes a plurality of display modules 30A to 30j, and frames 100 and 200 that supports the plurality of display modules so that the plurality of display modules are horizontally arranged in an M×N matrix form. The frame includes a frame panel 111, a module attachment layer 101 to which the plurality of display modules are attached and which has a thermal expansion coefficient more similar to a thermal expansion coefficient of the plurality of display modules than to a thermal expansion coefficient of the frame panel, as a module attachment layer to which the plurality of display module are attached, a cushion layer 121 or 220 provided between the frame panel and the module attachment layer and provided to have greater flexibility than flexibility of the module attachment layer and flexibility of the frame panel, as a cushion layer provided between the frame panel and the module attachment layer, and a frame chassis 131 disposed on a side opposite to one side of the frame panel on which the module attachment layer is disposed. According to such a configuration, the display device 1 according to an embodiment may improve reliability because the cushion layer 121 or 220 may absorb an impact caused by a thermal strain rate difference between the module attachment layer 101 and the frame panel 111.

The cushion layer may be configured to include a polyurethane foam.

The module attachment layer may include carbon fiber reinforced plastics (CFRP).

At least one of the frame panel or the frame chassis may be provided as a steel plate.

The display device may further include a board 25, as a board mounted on the frame chassis, including at least one of a power board, a control board, or a communication board, and the frame chassis may include a board mounting portion 132 formed to mount the board. According to such a configuration, the display device 1 according to an embodiment may omit a separate bracket for mounting the board 25 to the frame 100 or 200, thereby improving a manufacturing process.

The frame may include a chassis adhesive layer 141, which is provided as a double-sided tape, for attaching the frame chassis to the frame panel.

According to the spirit of the present disclosure, the display device may improve reliability, because a cushion layer is provided between a module attachment layer to which the plurality of display modules are attached and a frame panel having flatness for tiling the plurality of display modules.

According to the spirit of the present disclosure, the display device may improve a manufacturing process, because a board is mounted on a frame chassis having a board mounting portion for mounting the board.

According to the spirit of the present disclosure, the display device may improve a structure, because a frame panel having flatness for tiling the plurality of display modules and a frame chassis having a board mounting portion for mounting a board are respectively provided.

The effects obtained by the present disclosure are not limited to the aforementioned effects, and other effects, which are not mentioned above, will be clearly understood by those skilled in the art from the following description.

The above describes and illustrates specific embodiments. However, the present disclosure is not limited to the specific embodiments described above, and a person skilled in the art to which the present disclosure pertains would be able to make various modifications without departing from the scope of the technical spirit of the present disclosure as set forth in the following claims.

## Claims

1. A display device comprising:
a plurality of display modules; and
a frame configured to support the plurality of display modules such that the plurality of display modules are horizontally arranged in an M×N matrix form,
wherein the frame comprises:
a module attachment layer to which the plurality of display modules are attached;
a frame panel having a thermal expansion that is coefficient different from a thermal expansion coefficient of the module attachment layer; and
a cushion layer provided between the frame panel and the module attachment layer, the cushion layer being provided to absorb an impact caused by the module attachment layer and the frame panel being deformed to different sizes by heat.

2. The display device of claim 1, wherein
the module attachment layer has a thermal expansion coefficient more similar to a thermal expansion coefficient of the plurality of display modules than to the thermal expansion coefficient of the frame panel.

3. The display device of claim 1, wherein
the cushion layer comprises a polyurethane foam.

4. The display device of claim 1, wherein
the cushion layer comprises:
a base layer including the foam;
a first cushion adhesive layer disposed on one side of the base layer and adhered to the module attachment layer; and
a second cushion adhesive layer disposed on a side opposite to the one side of the base layer and adhered to the frame panel.

5. The display device of claim 1, wherein
the cushion layer is provided to have greater flexibility than a flexibility of the module attachment layer and a flexibility of the frame panel.

6. The display device of claim 1, wherein
the frame panel is provided to have greater stiffness than a stiffness of the module attachment layer.

7. The display device of claim 1, wherein
the module attachment layer comprises carbon fiber reinforced plastics (CFRP).

8. The display device of claim 1, wherein
the frame panel is provided as a steel plate.

9. The display device of claim 1, wherein
the frame comprises a frame chassis disposed on a side opposite to one side of the frame panel where the module attachment layer is disposed.

10. The display device of claim 9, wherein
the frame comprises a chassis adhesive layer for attaching the frame chassis to the frame panel.

11. The display device of claim 10, wherein
the chassis adhesive layer is provided as a double-sided tape.

12. The display device of claim 9, wherein
the frame chassis is provided as a steel plate.

13. The display device of claim 9, further comprising:
a board mounted on the frame chassis, the board comprising at least one of a power board, a control board, or a communication board.

14. The display device of claim 13, wherein
the frame chassis comprises a board mounting portion formed to mount the board.
